# FASCICULE DE BREVET EUROPEEN

(11) **EP 2 724 237 B1**
(45) Date de publication et mention de la délivrance du brevet: **28.03.2018**
(21) Numéro de dépôt: 12738481.6
(22) Date de dépôt: 22.06.2012
(51) Int. Cl.: G06F 12/02, G11C 16/34, G11C 16/10

(54) **PROCÉDÉ DE GESTION DE L'ENDURANCE DE MÉMOIRES NON VOLATILES**
VERFAHREN ZUR VERWALTUNG DER ROBUSTHEIT VON NICHTFLÜCHTIGEN SPEICHERN
METHOD OF MANAGING THE ENDURANCE OF NON-VOLATILE MEMORIES

(30) Priorité: 22.06.2011 FR 1101929
(43) Date de publication de la demande: 30.04.2014
(73) Titulaire: Starchip, 13590 Meyreuil (FR)
(72) Inventeur: CHARBOUILLOT, Samuel, F-83470 Saint Maximin la Sainte Baume (FR); FUSELLA, Yves, F-13400 Aubagne (FR); RICARD, Stéphane, F-13320 Bouc Belair (FR)
(74) Mandataire: Regimbeau
(86) Numéro de dépôt international: PCT/FR2012/000251
(87) Numéro de publication internationale: WO 2012/175827

(56) Documents cités:
- EP-A2- 1 182 669
- WO-A1-98/28748
- WO-A2-2007/134133
- US-A1- 2004 057 316
- US-A1- 2007 294 490

## Description

L'invention concerne un nouveau procédé de gestion de l'endurance destiné à des dispositifs de stockage de données, tels que par exemple des mémoires non volatiles et en particulier les mémoires non volatiles utilisables dans des applications embarquées. Ce procédé, même s'il s'appuie sur certains mécanismes connus de gestion de l'endurance, propose une nouvelle manière de les utiliser pour obtenir un bien meilleur résultat que les procédés antérieurs. Il a également pour but de proposer une solution très peu coûteuse et ne nécessitant pas de mémoire particulière.

### Contexte de l'invention

Dans le domaine des mémoires informatiques, les mémoires non volatiles se caractérisent par le fait qu'elles peuvent conserver leur contenu même lorsqu'elles ne sont plus alimentées. Néanmoins, une des caractéristiques limitatives de ces mémoires non volatiles est leur capacité d'endurance.

On définit la capacité d'endurance comme le nombre de fois que l'on peut effacer et réécrire une case mémoire avant que celle-ci ne soit plus en mesure d'être utilisée correctement. Une fois « usée », la case mémoire peut présenter soit des problèmes de stabilité des valeurs stockées, soit plus simplement ne pas restituer à la lecture la valeur qui a été préalablement écrite.

La présente invention s'attache plus spécifiquement à améliorer la capacité d'endurance des dispositifs de stockage de données, comme cela sera décrit en particulier dans le cas des mémoires non volatiles.

### La capacité d'endurance des mémoires non volatiles :

Suivant le type de mémoire non volatile (E²PROM, FLASH, MRAM ...), la capacité d'endurance est très variable. On peut parler de quelques milliers de cycles d'effacement/écriture sur certaines mémoires FLASH jusqu'à quelques centaines de milliers de cycles de programmation et d'effacement sur les meilleures d'entre elles (FLASH ou E²PROM).

Cette capacité d'endurance est évidemment fonction du type de mémoire (par exemple une mémoire E²PROM est souvent meilleure qu'une mémoire FLASH du point de vue de l'endurance), du procédé technologique de fabrication employé (par exemple un procédé utilisant une finesse de gravure de 0.09 pm), mais elle est aussi très variable de case mémoire à case mémoire (dans le cas des mémoires FLASH par exemple, on parle d'ailleurs de secteur de mémoire plutôt que de case mémoire).

Pour une technologie donnée, un fondeur devra garantir une capacité d'endurance minimale (par exemple de 10 000 cycles). Cette capacité d'endurance est appelée « endurance native » ou « endurance garantie G ». Dans la réalité, cela reviendra à assurer que le plus « mauvais » des secteurs peut supporter par exemple 10 000 cycles. Les autres secteurs pourront supporter des capacités bien au-dessus de 10 000 cycles avec une variabilité pouvant les emmener parfois à plusieurs centaines de milliers voire des millions de cycles.

Cette variabilité de la capacité d'endurance suit une distribution statistique dite « de Weibull ». Traditionnellement, les dispositifs de gestion d'endurance ne cherchent pas à tirer parti de cette répartition statistique. L'un des buts de cette invention sera de tirer parti de cette répartition statistique de la capacité d'endurance des mémoires non volatiles.

### Besoin d'endurance des applications :

Suivant le type d'utilisation de la mémoire non volatile, le besoin d'endurance est extrêmement variable, comme le montrent les exemples ci- dessous.

### Stockage permanent de programme :

Si la NVM (« Non Volatile Memory » en terminologie anglo-saxonne, ou mémoire non volatile) stocke un programme destiné à être exécuté par un microprocesseur (c'est le cas du programme dans les systèmes embarqués), le besoin d'endurance est très bas puisque ce programme ne va quasiment pas changer au cours du temps. Historiquement, ce type de contenu était stocké dans de la mémoire ROM (non modifiable) ce qui explique que le besoin d'endurance soit très bas.

### Stockage de fichiers :

C'est le cas typique par exemple des mémoires de type « Solid State Drive » (SSD) très utilisées de nos jours dans les ordinateurs de bureau ou ordinateurs portables, les clefs USB ou les baladeurs MP3. Pour ce type d'application, le besoin d'endurance est élevé mais sans règle d'utilisation définissable à priori. Tous les secteurs de la mémoire SSD ont à priori d'un point de vue statistique le même besoin d'endurance avec une exception toutefois pour la table d'allocation des fichiers qui va être mise à jour à chaque fois qu'un fichier est modifié et donc va avoir un besoin d'endurance bien plus élevé. A noter que si on stocke un système d'exploitation sur une mémoire de type SSD, on aura un besoin d'endurance assez bas pour cette zone, mais non détectable à priori, donc non exploitable pour réduire le besoin d'endurance. Typiquement, la granularité des fichiers dans les systèmes de stockage de fichiers est de l'ordre de 4 kilo-octets.

### Stockage de données :

Dans le domaine des applications embarquées par exemple, le microprocesseur va nécessiter en plus de la zone de stockage de programme, une zone de stockage de données. On peut retrouver dans cette zone un système de stockage de fichiers (comme dans l'exemple précédent), mais aussi des objets logiciels utilisés pour le fonctionnement courant (« buffers » ou zones tampons de communications, données de travail etc....). Ces objets se caractérisent en général par une taille faible (de l'ordre de grandeur d'un ou de plusieurs mots CPU jusqu'à quelques kilo-octets) mais avec un besoin d'endurance extrêmement élevé. A noter que la table d'allocation des fichiers du cas précédent (stockage de fichiers) peut très bien rentrer dans cette définition. La granularité des données va être ici de l'ordre du mot CPU (typiquement 16, 32 ou 64 bits).

Là aussi, un des buts de cette invention sera de tirer parti des caractéristiques intrinsèques des différents types de stockage pour pouvoir améliorer grandement l'efficacité de la gestion d'endurance. Un exemple d'implémentation non limitatif sera proposé dans le cas de systèmes embarqués intégrant un CPU et une mémoire non volatile.

### Etat de la technique

On connaît déjà un certain nombre de procédés de gestion de l'endurance des mémoires non volatiles. Sans être exhaustif, on va en rappeler certains, ainsi que leurs principales caractéristiques.

### La Correction d'erreur (ECC)

Ce procédé consiste à ajouter à chaque mot de mémoire une extension d'ECC (« Error Correction Code »). Ceci permet de corriger des erreurs de type unitaire, dites de « single bit fait » en terminologie anglo- saxonne, qui sont typiques des problèmes de rétention ou d'endurance.

La correction d'erreur a parmi ses avantages, le fait de permettre de multiplier l'endurance native de chaque secteur de mémoire par un facteur multiplicatif (2 à 4). Elle peut également aider à la résolution d'autres types de problèmes (comme par exemple une meilleure résistance aux perturbations et une meilleure rétention etc.). En outre, c'est un procédé local plutôt simple ne nécessitant pas de mémoire RAM supplémentaire. Il ne nécessite qu'un codeur/décodeur d'ECC, présentant un faible coût en portes logiques.

Par contre, la correction d'erreurs a aussi une série d'inconvénients. Ainsi, c'est un procédé très coûteux en mémoire non volatile additionnelle: typiquement 25% de la mémoire non volatile totale peut être occupée par l'ECC. En outre, seule une implémentation matérielle est possible. Le surcoût matériel doit être payé sur chaque mot mémoire quel que soit le besoin réel d'endurance. Une correction sur plus d'un bit peut être envisagée mais à des coûts prohibitifs.

En résumé, l'ECC est donc un système simple à mettre en oeuvre, permettant d'améliorer l'endurance native des mémoires non volatiles de manière artificielle mais au prix d'un coût en surface additionnelle de silicium important.

### Le Remplacement de secteurs mémoire (« Sector Sparing »)

Dans ce procédé, on ajoute à la mémoire non volatile un certain nombre de secteurs qui vont servir à remplacer les secteurs hors d'usage. Il sera nécessaire d'utiliser une table de translation d'adresses pour accéder aux secteurs remplacés à leur nouvel emplacement.

C'est une solution qui a été abondamment utilisée sur les circuits contrôleurs de disques durs, ne serait-ce que pour gérer les secteurs défectueux, à l'origine ou au cours du temps.

Parmi les avantages de ce procédé, on peut citer le fait que c'est une solution possible à mettre en oeuvre par logiciel. On peut décider du nombre de secteurs additionnels en fonction du besoin de remplacement visé (le procédé est dit modulable, ou encore « scalable » en terminologie anglo-saxonne). Parmi les inconvénients de ce procédé, on remarque qu'il nécessite d'utiliser un critère pour déterminer qu'un secteur est usé. Habituellement on utilise un compteur de cycles et on compare sa sortie avec la garantie d'endurance G donnée par le fournisseur de la mémoire. En outre, ce procédé ne sera pas suffisant si la majorité des secteurs a un besoin d'endurance supérieur à l'endurance native puisque le nombre de secteurs additionnels est limité. Ce procédé est donc surtout adapté à un petit nombre de prédateurs d'endurance.

Par ailleurs, il faudra sauvegarder (ou recréer) la table de translation d'adresses en cas de coupure de courant. Il convient donc de prévoir de la mémoire non volatile additionnelle pour cela. Le gain en endurance est globalisé et limité à N * endurance native où N est le nombre de secteurs additionnels. De plus, ce procédé devient rapidement plus complexe s'il faut organiser des remplacements de secteurs déjà remplacés.

En définitive, c'est un procédé performant, relativement peu coûteux en matériel et en performances CPU mais dont la capacité d'endurance additionnelle est limitée par le nombre de secteurs de remplacement alloués. Un tel système est par exemple décrit dans le document US 2004/0057316 A1.

On connaît également de l'état de la technique le document EP 1 182 669 A1, qui suggère d'utiliser des marges de tolérance à respecter pour garantir la possibilité de distinguer un bit programmé d'un bit effacé, lors d'un test d'usure.

### La répartition de la consommation d'endurance (« Wear Leveling » en terminologie anglo-saxonne)

Ce procédé de gestion d'endurance consiste à essayer de répartir de la manière la plus homogène possible le besoin d'endurance sur un maximum de secteurs afin de pouvoir profiter de l'endurance native de tous. Pour cela la technique générale consiste à écrire le nouveau contenu d'un secteur dans un secteur libre puis à invalider l'ancien secteur qui devient à son tour libre pour une prochaine opération. Une table d'allocation assez complexe est nécessaire pour stocker les relocalisations des secteurs.

Il y deux déclinaisons possibles connues de ce procédé:
**Le « Wear Leveling » dynamique :** dans le "Wear Leveling" dynamique, on n'utilise que les secteurs actifs (ceux qui sont mis à jour régulièrement) plus un secteur de remplacement pour les rotations. Cela limite la capacité d'endurance à un sous ensemble de la mémoire. Ce procédé est très utilisé dans les clefs USB. Un tel procédé est décrit notamment dans le document « US 2007/0294490 A1 (Freitas et al.) ».
**Le « Wear Leveling » statique :** ici, en plus du "Wear Leveling" dynamique, on échange de temps en temps des secteurs actifs avec des secteurs inactifs pour accroître la capacité d'endurance. Ce procédé est utilisé par exemple dans les mémoires de type SSD mais est bien plus complexe.

Parmi les avantages du « Wear Leveling », on note qu'il permet théoriquement d'avoir une endurance globale égale à la somme de l'endurance native de TOUS les secteurs de la mémoire. Cette méthode donne donc le plus haut niveau d'endurance possible. Elle permet de traiter un grand nombre de prédateurs d'endurance. Et c'est une solution possible à mettre en oeuvre en logiciel.

Parmi les inconvénients de ce procédé, on remarque qu'en pratique l'endurance globale est limitée aux secteurs actifs (pour le « Wear Leveling » dynamique). Sinon, il faut organiser la rotation de secteurs inactifs ce qui augmente beaucoup la complexité des algorithmes, comme dans le cas du « Wear Leveling » statique. En outre, il y a une baisse de performances d'accès à la mémoire lors de la rotation des secteurs inactifs ou l'identification de périodes où la rotation peut être faite en temps masqué.

Par ailleurs, l'indirection d'adresse étant généralisée à toute la mémoire, ce procédé affecte également les performances de lecture et d'exécution de code (dite « fetch »), si le code est contenu dans la mémoire Flash, et pas seulement les performances de lecture de données (dite « data read »). En outre, le besoin de mémoire RAM est très important pour stocker les relocalisations de secteurs. De plus, ce procédé impose la nécessité absolue de savoir recréer la table d'allocation au démarrage du circuit et donc de stocker son contenu en mémoire non volatile d'une manière ou d'une autre. La rotation des secteurs étant homogène, le procédé va s'arrêter lorsque le plus faible des secteurs impliqués dans la rotation va atteindre sa limite d'endurance native.

### Inconvénients de l'état de la technique

En résumé, comme on le constate, aucun des procédés de gestion d'endurance connus ne sait tirer parti de manière fine et granulaire des caractéristiques intrinsèques d'endurance des mémoires, ni des différences de besoin d'endurance en fonction des applications visées pour les mémoires. Chacun des procédés connus repose sur des caractéristiques fixes comme un lissage systématique du besoin d'endurance global de l'application sur une pluralité de secteurs (wear-leveling), ou bien sur un remplacement de secteurs en fonction d'un critère (« sector sparing »), mais aucun n'essaie de tirer parti de la dispersion importante de la capacité d'endurance par secteur (courbe de Weibull) ou bien des besoins intrinsèques d'endurance des applications.

### But de l'invention

[1] Un but général de l'invention est par conséquent de proposer un procédé de gestion de l'endurance d'une mémoire non volatile qui soit à même de remédier aux inconvénients des procédés de gestion d'endurance connus, afin d'améliorer l'endurance globale d'une mémoire.
[2] Un autre but de l'invention est d'utiliser le système de gestion d'endurance et en particulier d'extraction de la capacité réelle d'endurance de chaque secteur pour limiter le stress appliqué aux cellules mémoire lors de l'effacement et ainsi augmenter naturellement la capacité réelle d'endurance de tous les secteurs utilisés.
[3] Un but plus spécifique de l'invention est de proposer un procédé de gestion de l'endurance d'une mémoire apte à utiliser la limite réelle, physique, d'endurance de chaque secteur de mémoire en temps réel afin de tirer le maximum d'endurance possible de chaque secteur sans à priori sur la limite réelle de celui-ci ou sans utiliser les garanties d'endurance fournies par les fondeurs.
[4] Un autre but de l'invention est de tenir compte des besoins spécifiques d'endurance des applications pour obtenir une adéquation entre la capacité d'endurance de la mémoire et le besoin réel des applications.
[5] Un autre but de l'invention est de concevoir un procédé et un système extrêmement peu coûteux en surface silicium par rapport aux systèmes conventionnels tels que celui décrit dans US 2004/0057316 A1 , tout en offrant une bien meilleure efficacité.
[6] Un autre but de l'invention est de pouvoir obtenir un procédé et un système complètement transparent pour l'utilisateur final (le CPU) et dont la pénalité sur les performances d'accès est quasi négligeable.
[7] Un autre but de l'invention est de pouvoir se passer d'une mémoire non-volatile spécialement développée pour gérer l'endurance, mais au contraire utiliser une mémoire parfaitement générique.
[8] Un autre but de l'invention est d'obtenir un système modulable, ou encore « scalable » en terminologie anglo-saxonne afin de laisser à l'utilisateur final (le CPU) le soin de faire un choix entre capacité d'endurance ou mémoire utilisable.

### Résumé de l'invention

Ces buts sont atteints par le procédé de gestion d'endurance selon l'invention.

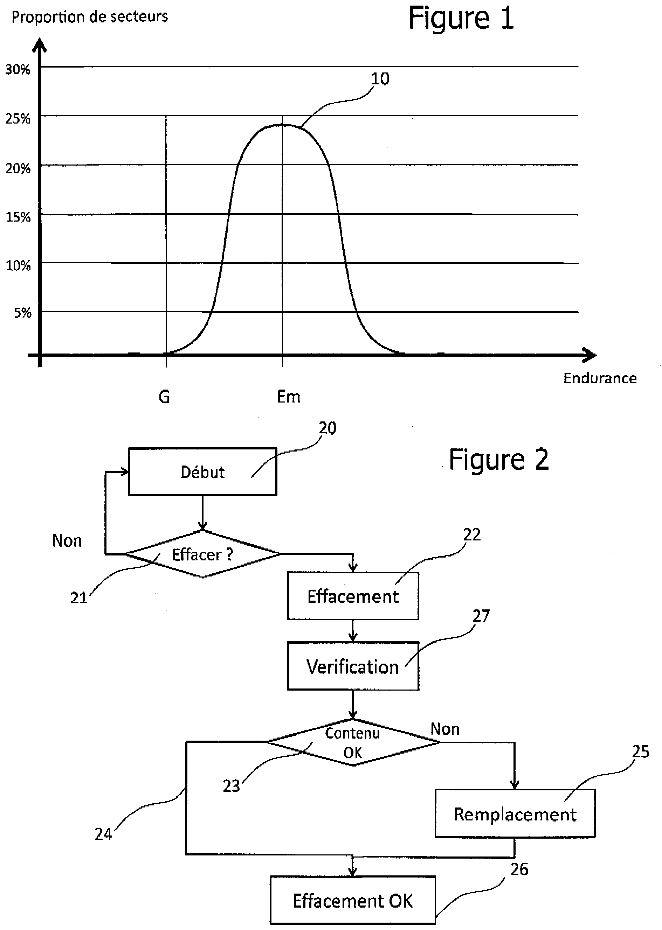

L'invention utilise un procédé de gestion classique de l'endurance des systèmes de stockage de données faisant appel à un ensemble de secteurs assortis d'une capacité d'endurance native (G) garantie par la fonderie, d'une pluralité de secteurs de travail, et d'une pluralité de secteurs de remplacement aptes à former un réservoir d'endurance, certains des secteurs de travail étant destinés à être remplacés par des secteurs de remplacement lorsque lesdits secteurs de travail sont usés après un certain nombre de cycles de programmation et/ou d'effacement. L'invention utilise également une zone de management de la mémoire non volatile permettant de stocker les informations concernant les secteurs usés ainsi que leur remplaçants (c'est la table de translation). Un procédé basique de « sector sparing » est par exemple décrit dans « US 2004/0057316 A1 » et repris ici dans le paragraphe « Etat de la Technique ». Il peut être schématisé par la figure 2.

Classiquement, dans ce type de procédé, on trouve une étape de détection d'effacement non conforme d'un secteur 22 suivie d'une étape de remplacement du secteur usé par un secteur de remplacement 25.

La présente invention se propose d'améliorer le procédé et l'algorithme de base de « sector sparing » par un certain nombre de moyens additionnels qui sont résumés ci-dessous.

Un premier moyen additionnel consiste à effectuer l'étape d'effacement 22 de manière particulière, selon trois méthodes envisagées.

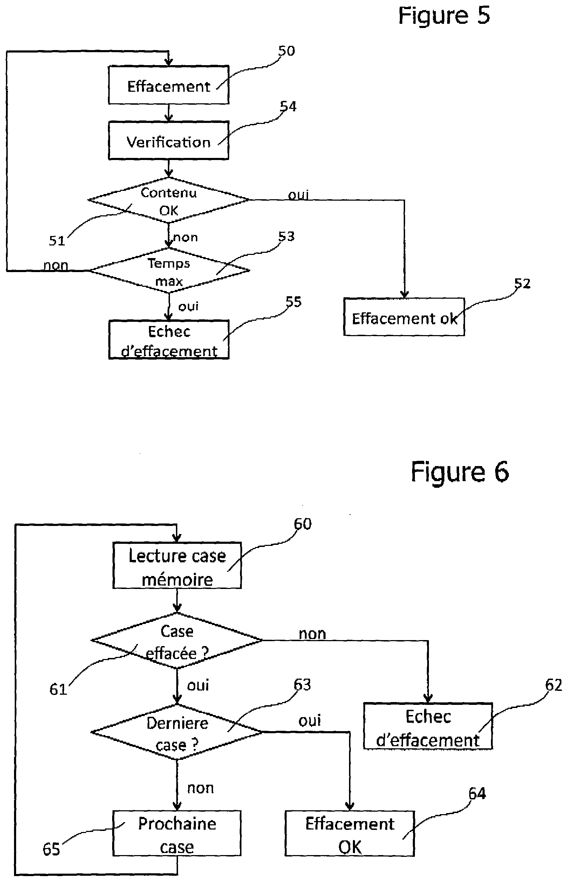

Une première méthode pour ce faire pourrait consister à vérifier de manière automatique, par exemple par une machine d'état (figure 6) que toutes les cases mémoire du secteur effacé ont bien une valeur conforme à l'effacement en utilisant des commandes de lecture normale. Cette méthode à néanmoins le désavantage de ne pas détecter des valeurs limites d'effacement dont certains bits pourraient changer d'état par des phénomènes de mauvaise rétention.

Une seconde méthode pourrait consister à utiliser le mécanisme automatique de la méthode précédente en répétant plusieurs fois la lecture 60 de la figure 6 afin de piéger une éventuelle instabilité (« Retry » en terminologie anglo-saxonne).

Toutefois, la présente invention utilise une troisième méthode consistant à utiliser le mécanisme automatique de la première méthode en utilisant cette fois une lecture en mode sévérisé (« Margin mode ») pour l'étape 60 de la figure 6, lorsque ce mode est disponible sur la mémoire. Ce mode sévérisé, connu en tant que tel et souvent utilisé en test des mémoires non volatiles pour trier les secteurs non conformes à une spécification de fabrication {« yield » en terminologie anglo-saxonne) pourra être utilisé ici de façon innovante pour détecter une faiblesse du secteur avant qu'il ne soit complètement usé. En d'autres termes, lorsqu'une vérification est correctement effectuée dans ce mode sévérisé, on peut garantir que la lecture du secteur se passera toujours de manière correcte en mode normal. Ceci permet donc de s'affranchir des problèmes de rétention décrits à la première méthode.

Quoi qu'il en soit, ces trois méthodes permettent d'extraire de chaque secteur le maximum d'endurance sans tenir compte de la valeur d'endurance garantie G ou d'un quelconque autre critère fixe (une valeur de référence par exemple). Ceci permet d'atteindre le but [3] de l'invention et d'adapter le procédé de « sector sparing » aux spécificités de la courbe de Weibull en extrayant de chaque secteur le maximum d'endurance possible. La simplicité et le faible cout de la machine d'état de vérification permet également d'atteindre le but [5] (faible cout) ainsi que [6] (transparence et faible pénalité en performances).

Un second moyen additionnel cumulé avec le précédent consiste en une machine d'état (figure 5), qui permet de découper le temps d'effacement prescrit par le fondeur (c'est-à-dire le temps pendant lequel une source de haute tension est appliquée sur les points mémoire du secteur pour les effacer). Ce second moyen permet de vérifier à des points temporels intermédiaires si la qualité d'effacement est suffisante pour pouvoir stopper la procédure d'effacement. Ceci permet de limiter le stress dû à l'effacement sur les points mémoire et ainsi augmenter significativement la capacité d'endurance intrinsèque du secteur considéré, ce qui permet d'atteindre le but [2]. La simplicité et le faible cout de la machine d'état gérant le découpage du temps d'effacement permet également de satisfaire au but [5] (faible cout) ainsi que [6] (transparence et faible pénalité en performances), il permet en outre d'avoir en moyenne un temps d'effacement bien plus faible que la prescription de la fonderie puisque la plupart du temps, seulement une fraction du temps d'effacement prescrit sera nécessaire pour effacer correctement le secteur.

On prévoit un troisième moyen additionnel qui consiste à adapter l'algorithme de « sector sparing » aux besoins spécifiques des applications (but [4]). Une implémentation particulière de ce troisième moyen permet de s'adapter aux besoins spécifiques du monde des applications embarquées. Ces applications se caractérisent souvent par un besoin extrêmement fort d'endurance sur un petit nombre de secteurs et un besoin moyen, voire faible, sur les autres secteurs. Les premier et second moyens contribuent déjà fortement pour les besoins d'endurance faibles et intermédiaires, en maximisant la capacité intrinsèque d'endurance de tous les secteurs. Pour les besoins forts d'endurance, on prévoit donc ce troisième moyen additionnel permettant d'effectuer des remplacements multiples du même secteur d'origine. Ainsi, la capacité intrinsèque d'autant de secteurs qu'il faudra sera additionnée pour couvrir le besoin d'endurance élevé et ceci jusqu'à ne plus avoir de secteur de remplacement disponible.

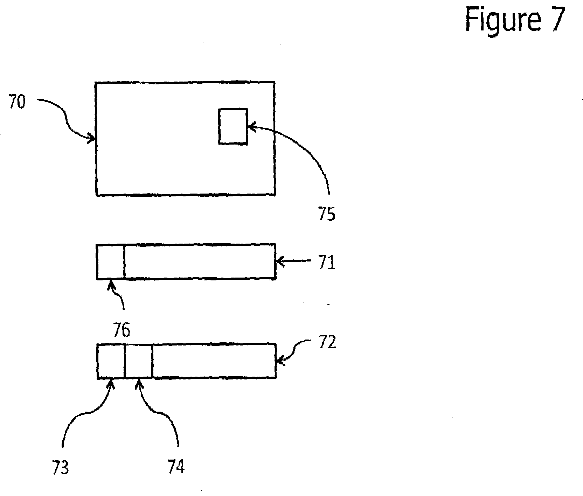

Dans une première implémentation de ce troisième moyen, ceci est rendu possible car on utilise une mémoire parfaitement générique à structure régulière (but [7]) où il n'y a pas de différence physique entre un secteur d'origine et un secteur de remplacement). Ainsi, un secteur de remplacement ayant remplacé un secteur d'origine peut à son tour devenir un secteur d'origine pour un prochain remplacement. Comme le montre la figure 7, ceci est obtenu en utilisant une zone de management de la mémoire non volatile 70 où chaque élément de la zone est spécifique à un secteur remplacé et représente l'adresse du secteur de remplacement. On pourra donc, en suivant le cheminement des remplacements successifs d'un secteur d'origine, finir par aboutir à la dernière version du secteur d'origine après de multiples remplacements. Dans cette implémentation, on pourra retrouver la dernière version d'un secteur remplacé au moment où le CPU accède au secteur d'origine.

Dans une seconde implémentation plus optimisée de ce troisième moyen, on pourra reconstruire le cheminement au démarrage du circuit et stocker dans une RAM le raccourci entre le secteur d'origine et le dernier secteur de remplacement. Cette seconde version de l'implémentation est plus couteuse que la première puisqu'elle utilise une RAM additionnelle. Par contre, elle permet de respecter le but [6] (transparence et faible pénalité d'accès).

Un quatrième moyen additionnel consiste à sécuriser la création de la zone de management de la mémoire non volatile. Cette zone est écrite à chaque remplacement pour stocker, dans un élément dédié au secteur remplacé, l'adresse du secteur remplaçant. Perdre le contenu de cette zone reviendrait donc à rendre le mémoire inutilisable. Ce quatrième moyen utilise un mécanisme de sécurité pour se prémunir de la perte de d'alimentation qui pourrait conduire à une corruption de la zone de management. Ce mécanisme consiste à effectuer l'algorithme suivant selon la figure 7. La première étape de ce mécanisme consiste à écrire l'adresse du secteur d'origine 73 dans une première zone de signature 72.

Ensuite une signature de fin d'écriture 74 est écrite afin d'assurer la validité de l'adresse précédemment programmée.

Une fois ces deux étapes effectuées, l'élément 75 de la zone de management 70 associé au secteur remplacé est chargé avec l'adresse du secteur de remplacement.

Afin de valider cette dernière opération une signature de fin de remplacement 76 sera à nouveau programmée dans une seconde zone de signature 71).

Ce mécanisme étant séquence dans le temps, dans le cas d'une perte d'alimentation, une seule étape sera corrompue. Ainsi il sera aisé de déterminer l'étape où l'algorithme s'est terminé et le reprendre afin de l'achever.
De manière générale, l'adjonction à l'algorithme de « sector sparing » classique d'un ou de plusieurs de ces quatre moyens additionnels permet notamment d'adapter cet algorithme aux besoins particuliers des mémoires embarquées aussi bien en termes de capacité élevée d'endurance, de sécurité de fonctionnement, de faible pénalité de temps d'accès et de contrainte de faible cout.

L'ensemble des buts [1] à [8] sont atteints par le procédé selon l'invention, y compris les exigences d'utilisation de mémoire générique puisque l'ensemble des dispositifs ne requiert aucune caractéristique particulière de la mémoire. De plus, l'objectif (8] de système scalable est également atteint puisque la limite entre secteurs d'origine et secteurs de remplacement peut être déterminée par l'utilisateur final (le CPU). En définitive, l'invention a pour objet le procédé tel que défini dans la revendication 1.

Si la lecture se passe de manière correcte en mode sévérisé, cela permet de garantir que la lecture du secteur se passera toujours de manière correcte en mode normal.

Selon le procédé, une impulsion d'effacement unique d'un secteur est remplacée par plusieurs impulsions plus courtes appliquées de façon séquentielle, et un test de qualité d'effacement est pratiqué après chaque impulsion, un secteur de mémoire de travail étant déclaré usé si lesdits tests de qualité restent négatifs après un nombre maximal prédéfini d'impulsions et de tests. De cette manière, on limite le stress dû à l'effacement sur les points mémoire et on augmente significativement la capacité d'endurance intrinsèque du secteur considéré.

Idéalement, on utilise une mémoire parfaitement générique à structure régulière où il n'y a pas de différence physique entre un secteur d'origine et un secteur de remplacement. Ainsi, le nombre de secteurs de remplacement peut être déterminé par l'utilisateur final en fonction des besoins d'endurance visés. En outre, un secteur de travail remplacé par un secteur de remplacement devient lui-même un secteur de travail susceptible d'être remplacé lorsqu'il aura atteint son seuil d'usure physique.

Le procédé selon un mode de réalisation particulier de l'invention prévoit que pour reconstruire le cheminement entre secteurs remplacés et secteurs de remplacement, on utilise une zone de management de la mémoire non volatile où chaque élément de la zone est spécifique à un secteur de remplacement et représente l'adresse du secteur d'origine remplacé.

En outre, le chemin de reconstruction entre secteur d'origine et secteur de remplacement utilisant la zone de management est déterminé en temps réel lors de l'accès au secteur d'origine.

Selon un mode de réalisation particulier de l'invention on reconstruit le cheminement entre secteur d'origine et secteur de remplacement au démarrage du circuit et on stocke dans une mémoire RAM le raccourci entre le secteur d'origine et le dernier secteur de remplacement.

Selon une variante préférée du procédé, la manière de mettre à jour la zone de management est conçue pour être robuste par rapport à des pertes éventuelles d'alimentation, de manière à éviter toute corruption de ladite zone de management.

L'invention a également pour objet un dispositif pour la mise en oeuvre du procédé de gestion d'endurance tel que décrit ci-dessus, caractérisé en ce qu'il comporte une mémoire partitionnée en une pluralité de secteurs de travail et de secteurs de remplacement, une zone de management des secteurs de remplacement, un automate conçu et apte à exécuter les étapes du procédé décrit. D'autres caractéristiques et avantages de l'invention apparaîtront à la lecture de la description détaillée des dessins annexés, dans lesquels :
- la figure 1 représente une courbe de distribution de l'endurance native des secteurs d'une mémoire;
- la figure 2 représente un organigramme des étapes d'un procédé connu de sector sparing;
- la figure 3 représente une vue schématique de l'organisation d'une mémoire non volatile à laquelle peut être appliqué le procédé selon l'invention;
- la figure 4 représente de façon schématique le principe mis en oeuvre pour la mesure de la qualité d'effacement;
- la figure 5 représente de façon plus détaillée l'organigramme des étapes correspondant à l'opération d'effacement dans l'organigramme de la figure 2 lorsque ledit effacement est effectué en plusieurs étapes temporelles ;
- la figure 6 représente un organigramme des étapes d'un procédé de vérification de l'effacement utilisé dans un procédé de sector sparing;
- la figure 7 représente une vue schématique de l'organisation de la zone de management et des 2 zones de signature utilisées pour recréer le cheminement entre secteurs d'origine et secteurs de remplacement.

On se réfère à la figure 1. On a représenté dans cette figure un graphe de la répartition statistique des secteurs d'une mémoire en fonction de leur capacité d'endurance. On aura donc en ordonnée, le pourcentage des secteurs pour une endurance donnée en abscisse. L'endurance en abscisse peut être exprimée en un nombre d'effacements possibles, qui représente en fait la capacité d'endurance du secteur.

Comme on le voit sur le graphe 10, la distribution de la proportion des secteurs en fonction de l'endurance a une forme de gaussienne, répartie autour d'une valeur moyenne notée EM, et tous les secteurs ont une endurance supérieure à l'endurance minimale garantie pour les secteurs de cette mémoire, encore appelée endurance native ou intrinsèque, et notée G.

En pratique, le fabricant de la mémoire va donner une valeur d'endurance garantie G, indiquant que l'endurance de tous les secteurs est supérieure à cette valeur d'endurance garantie. Or la forme des courbes d'endurance est en pratique très étalée (elle n'est pas représentée à l'échelle dans la figure 1), ce qui signifie que la valeur de l'endurance minimale G est très inférieure à la valeur d'endurance moyenne EM. Un des objectifs essentiels du procédé de gestion d'endurance selon l'invention est de faire en sorte que grâce au procédé, la valeur minimale d'endurance réellement utilisable soit très supérieure, à savoir supérieure de plusieurs ordres de grandeur, à ce qu'elle est dans l'état de la technique.

On se réfère maintenant à la figure 2 représentant un organigramme des étapes du procédé classique de « sector sparing ». Ce procédé est mis en oeuvre par une machine d'état, et appliqué à un secteur courant de la mémoire.

A partir d'un état de repos 20, on décide en 21 s'il faut effacer le secteur courant. Dans l'affirmative, en 22, on procède à l'effacement, ce qui consiste à envoyer au secteur courant de la mémoire une tension suffisante pour provoquer l'effacement des cellules. Puis en 27 et 23 on procède à une vérification de la qualité d'effacement, selon une méthode de vérification choisie parmi plusieurs méthodes disponibles. Si le résultat du test de la qualité d'effacement est bon (branche 24), on passe à l'étape 26 et on considère que l'effacement a été fait de façon satisfaisante. Si par contre le résultat de la qualité du test d'effacement en 23 est mauvais, on considère que le secteur courant de la mémoire est usé, et on le remplace en 25 par un secteur de remplacement bon (et au préalable effacé), ce qui revient à considérer que l'effacement a été effectué (repère 26).

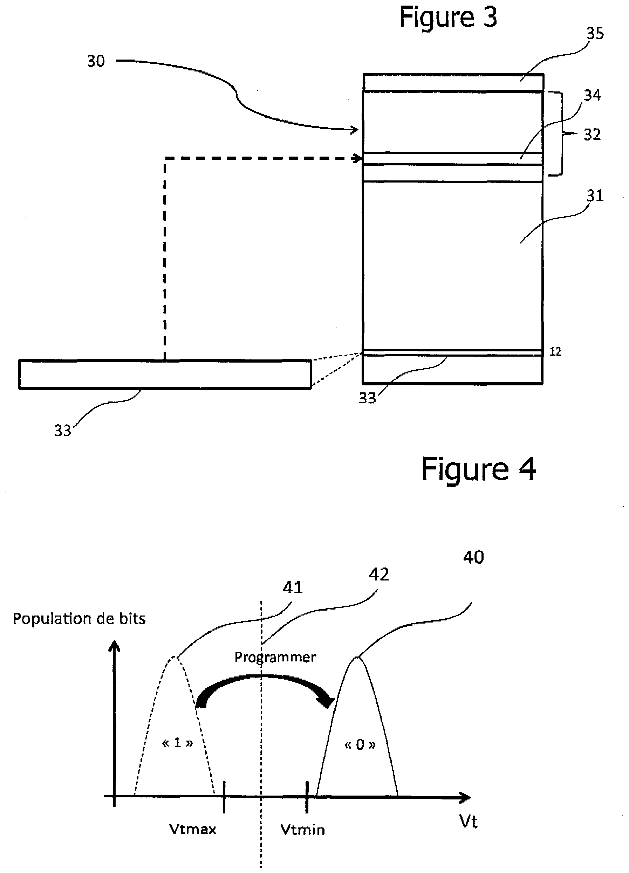

On se réfère à la figure 3 montrant de façon schématique l'organisation d'une mémoire 30 non volatile, par exemple de type FLASH, comprenant une zone de travail 31 et une zone de remplacement 32, chaque zone étant découpée en secteurs, par exemple des secteurs de travail 33 et des secteurs de remplacement 34. Quand le test d'effacement appliqué à un secteur de travail indique que ce secteur est usé, on redirige ce secteur vers un secteur donné parmi les secteurs de remplacement 34 de la zone de remplacement 32. Le secteur de remplacement précis de la zone de remplacement qui sera affecté au remplacement du secteur de travail, sera déterminé dans une zone de management de l'endurance 35 permettant de garder la trace des remplacements effectués.

Un secteur de travail 33 de la mémoire de travail 31 peut être remplacé un nombre entier n de fois, n étant inférieur à un nombre N correspondant au nombre de secteurs de remplacement 34 contenus dans la zone de remplacement 32. L'invention prévoit que les secteurs 34 de la zone de remplacement 32 peuvent eux aussi être remplacés par d'autres secteurs de la zone de remplacement, au même titre que les secteurs de travail, ce qui permet encore d'augmenter la capacité d'endurance de la mémoire 30.

Pour mettre en oeuvre le procédé ci-dessus, on utilisera un automate (non représenté), une zone de management de l'endurance 35, une mémoire non volatile 30 et un dispositif de mesure (non représenté) de l'usure des secteurs de la mémoire.

L'automate peut être réalisé sous la forme d'une machine d'états matérielle ou logicielle.

La mémoire non volatile 30 peut être une mémoire physique ou un autre dispositif de stockage de données.

Le dispositif de mesure peut mettre en oeuvre un mode de lecture normal, ou un mode de lecture plus sévère de la mémoire ou tout dispositif permettant de déterminer qu'une opération d'effacement ou de programmation n'a pas été effectuée de manière correcte- Un exemple de dispositif de mesure de l'usure des secteurs va être décrit en relation avec la figure 4, dans laquelle on a représenté un graphe comportant en ordonnée la population de bits d'un secteur donné de la mémoire, en fonction de la tension de seuil Vt des transistors mémoire, représentée en abscisse.

Par convention, on considère qu'un bit est «programmé» ou à un niveau zéro, lorsque la tension de seuil du transistor correspondant est supérieure à une tension limite notée Vtmin, qui dépend de la technologie utilisée pour la mémoire. Inversement, on considère qu'un bit est «effacé» ou à niveau un, lorsque la tension de seuil du transistor correspondant à ce bit est inférieure à une tension limite notée Vtmax.

Comme cela est représenté sur la figure 4, les tensions de seuil pour un point mémoire programmé (0) ou effacé (1) varient, et les populations respectives des bits à zéro ou à un en fonction de la tension de seuil appliquée, suivent des distributions 40,41 de forme généralement gaussienne.

En lecture dite en « mode normal », on compare la tension de seuil Vt du point mémoire courant à une référence fixe, notée Normal Vref, située entre les tensions limites Vtmin et Vtmax (et schématisée par un trait interrompu 42), et on classe le point mémoire donné comme étant à zéro ou à un en fonction du résultat de la comparaison par rapport à la tension de seuil de référence normale, NormalVref.

En lecture dite en « mode sévérisé », on compare la tension de seuil du point mémoire courant à une autre référence, notée Margin Vref. (non représentée), supérieure à Vtmax mais inférieure à la référence précédente NormalVRef. Par conséquent, un point mémoire ayant une tension de seuil Vt située entre la référence de lecture en mode normal, NormalVRef, et la référence de lecture en « mode sévérisé », MarginVRef, pourrait être considéré comme ayant une valeur différente en mode normal (par exemple un zéro à la place d'un un, ou inversement) mais serait considéré comme un « zéro » en mode sévérisé.

Ces modes de lecture de la tension de seuil d'un point mémoire, qu'il s'agisse du mode normal ou du mode sévérisé, peuvent être utilisés dans le procédé selon l'invention pour mesurer la qualité d'effacement d'un secteur. Ils vont en effet permettre de détecter si un secteur est réellement bien effacé sans se baser sur la limite théorique d'endurance de celui-ci, mais bien sur ses qualités physiques intrinsèques. Le procédé permet aussi de garantir que la lecture de vérification de l'effacement est robuste.

On se réfère à la figure 5 représentant une variante du procédé d'effacement d'un secteur de mémoire, dans laquelle l'étape d'effacement normale 22 à impulsion unique de l'organigramme de la figure 2, est remplacée par un effacement à impulsions d'effacement multiples.

De façon générale, effacer un point mémoire consiste à lui appliquer une haute tension et à lui amener une certaine énergie, ce qui finit par l'abimer et par le rendre illisible.

Dans un mode de réalisation de l'invention, il est prévu de n'appliquer à chaque point mémoire que la tension d'effacement nécessaire, ce qui permet d'augmenter la durée de vie de chaque point mémoire, et par conséquent la durée de vie du réservoir d'endurance et donc de la mémoire tout entière.

A cet effet, un mode de réalisation particulier de l'invention prévoit de remplacer une impulsion d'effacement normale et unique 22, par plusieurs impulsions plus faibles appliquées de façon séquentielle 50, avec un test de qualité d'effacement 54 pratiqué après chaque impulsion d'effacement. Les impulsions faibles étant appliquées jusqu'à ce que le test de qualité d'effacement soit positif, ou jusqu'à ce qu'un nombre prédéfini d'impulsions faibles aient été appliquées 53. Si le test de qualité d'effacement est encore mauvais après l'application du nombre maximal prédéfini d'impulsions faibles, on considère que le secteur de mémoire est usé 55 et on procède à son remplacement par allocation d'un secteur de la zone de remplacement.

On voit bien que si le test de qualité d'effacement donne un bon résultat après un nombre d'impulsions inférieur au nombre maximal prédéfini d'impulsions 52, la quantité totale d'énergie appliquée pour effacer ce secteur aura été inférieure à celle d'un effacement classique, ce qui contribue à prolonger la durée de vie de la mémoire.

Comme expliqué précédemment, le test de qualité d'effacement peut être effectué en mode normal, ou en mode sévérisé. On se réfère à la figure 6 représentant une procédure classique de vérification d'effacement.

A l'étape 60 on lit une case mémoire du secteur effacé puis on vérifie en 61 que la case est correctement effacée. Dans l'affirmative, on passe à la case suivante du secteur 65 et on réitère les opérations 60, 61 et 65 tant que l'opération 63 ne détecte pas la dernière case du secteur. Si on atteint la dernière case du secteur sans échec d'effacement 61, on conclut en 64 par un effacement validé. En cas d'échec d'effacement 61, on conclut en 62 par un effacement non valide.

On se réfère à la figure 7 représentant le procédé correspondant au quatrième moyen :

Ce procédé utilise une zone de management 70 ainsi que deux zones de signatures 71 et 72.

La première étape de ce procédé consiste à écrire l'adresse du secteur d'origine 73 dans une première zone de signature 72.

Ensuite une signature de fin d'écriture 74 est écrite afin d'assurer la validité de l'adresse précédemment programmée.

Une fois ces deux étapes effectuées, l'élément de la zone de management associé au secteur remplacé 75 est chargé avec l'adresse du secteur de remplacement.

Afin de valider cette dernière opération une signature de fin de remplacement 76 sera à nouveau programmée dans une seconde zone de signature 71.

### Avantages de l'invention

L'invention telle que décrite permet d'atteindre les buts fixés. Elle permet avant tout d'atteindre des capacités d'endurance très élevées, presque équivalentes à celles obtenues par les méthodes dites de « Wear Leveling », mais sans les inconvénients de celles-ci.

L'invention est par conséquent particulièrement utile dans des environnements où tous les objets de données n'ont pas un besoin élevé d'endurance, ce qui est en général le cas notamment dans des applications de type logiciel embarqué et sécurisé, où seul un petit nombre d'objets nécessite une endurance élevée. Cette méthode prend alors tout son sens pour un coût très limité, mais elle est utilisable sur tout autre type d'application ou de dispositif de stockage connu ou à venir et ayant des besoins d'endurance similaires.

Le mécanisme de mesure de la qualité d'effacement par rapport à un critère d'usure physique et non simplement statistique est absolument fondamental pour assurer une endurance globale élevée de la mémoire. Cela permet à la fois de maximiser l'utilisation d'un secteur d'origine avant d'avoir à le remplacer (et donc de diminuer le besoin en secteurs de remplacement) mais également de maximiser la valeur du « réservoir d'endurance ».

L'utilisation du mécanisme de mesure de la qualité d'effacement permet également de n'appliquer que la quantité nécessaire de tension d'effacement à un secteur et donc d'en maximiser la durée de vie.

En pratique, le nombre de secteurs de remplacement nécessaires peut être aisément ajusté en fonction du besoin d'endurance visé.

En outre, le procédé selon l'invention permet d'éliminer rapidement du réservoir d'endurance les secteurs faibles demandant beaucoup d'endurance.

Le procédé selon l'invention n'est que faiblement pénalisant en terme de coût de mémoire supplémentaire, ce coût est en effet très faible puisque proportionnel à l'endurance globale visée et non pas à la taille de la mémoire.

Le besoin en mémoire RAM et en logique de contrôle est extrêmement faible surtout comparé à celui requis par les procédés dits de « wear Leveling » dynamique ou statique.

Le procédé selon l'invention permet une utilisation optimale de l'endurance des secteurs participant au système. Les secteurs d'origine ne demandant pas plus d'endurance qu'ils ne sont capables eux-mêmes de fournir n'entrent jamais dans le système de remplacement (à la différence du « wear Leveling » où théoriquement tous les secteurs participent au système). Il y a donc une baisse drastique du nombre de secteurs de remplacement nécessaires, grâce à l'utilisation optimale des secteurs d'origine.

L'invention s'applique aujourd'hui essentiellement aux mémoires non volatiles mais est susceptible de s'appliquer à tout système de stockage de données présentant des phénomènes d'usure.

## Revendications

1. Procédé de gestion de l'endurance d'un système de stockage de données pourvu d'un ensemble de secteurs (33, 34) assortis d'une capacité d'endurance native garantie (G), comportant les étapes consistant à :
- partitionner ledit système de stockage de données en une pluralité de secteurs de travail (33), et en une pluralité de secteurs de remplacement (34) aptes à former un réservoir d'endurance, certains des secteurs de travail (33) étant destinés à être remplacés par des secteurs de remplacement (34) lorsque lesdits secteurs de travail (33) sont usés après un certain nombre de cycles de programmation et/ou d'effacement;
- définir une zone de management d'adresses (35) permettant de retrouver l'emplacement des secteurs de remplacement affectés à des secteurs de travail usés ;
- déterminer, secteur par secteur, si un secteur de travail courant (33) est physiquement usé, et exécuter une étape de remplacement de ce secteur de travail (33) par un secteur de remplacement (34), uniquement lorsque ledit secteur de travail courant (33) est déclaré physiquement usé ;
- mesurer l'usure d'un secteur, en procédant à une lecture automatique de la qualité d'effacement des points mémoire du secteur par rapport à un critère de lecture en mode sévérisé, c'est-à-dire plus sévère qu'un critère de lecture en mode normal, avec une comparaison d'une tension de seuil Vt du point mémoire courant à une référence fixe, notée Normal Vref, située entre deux tensions limites Vtmin et Vtmax en mode normal et avec une comparaison de la tension de seuil du point mémoire courant à une autre référence, notée Margin Vref, supérieure à Vtmax mais inférieure à la référence Normal Vref en mode sévérisé, **caractérisé en ce qu'**une impulsion d'effacement unique d'un secteur est remplacée par plusieurs impulsions plus courtes appliquées de façon séquentielle, et **en ce qu'**un test de qualité (54) d'effacement est pratiqué après chaque impulsion, un secteur de mémoire de travail étant déclaré usé si lesdits tests de qualité restent négatifs après un nombre maximal prédéfini d'impulsions et de tests.

2. Procédé selon l'une quelconque des revendications précédentes, **caractérisé en ce que** :
- on utilise une mémoire parfaitement générique à structure régulière où il n'y a pas de différence physique entre un secteur d'origine et un secteur de remplacement ;
- le nombre de secteurs de remplacement (34) peut être déterminé par l'utilisateur final en fonction des besoins d'endurance visés.
- un secteur de travail (33) remplacé par un secteur de remplacement (34) devient lui-même un secteur de travail (33) susceptible d'être remplacé lorsqu'il aura atteint son seuil d'usure physique.

3. Procédé selon la revendication 2, **caractérisé en ce que** pour reconstruire le cheminement entre secteurs remplacés et secteurs de remplacement (34), on utilise une zone de management de la mémoire non volatile où chaque élément de la zone est spécifique à un secteur de remplacement et représente l'adresse du secteur d'origine remplacé.

4. Procédé selon la revendication 3, **caractérisé en ce que** le chemin de reconstruction entre secteur d'origine et secteur de remplacement (34) utilisant la zone de management est déterminé lors de l'accès au secteur d'origine en temps réel.

5. Procédé selon la revendication 3, **caractérisé en ce qu'**on reconstruit le cheminement entre secteur d'origine et secteur de remplacement (34) au démarrage du circuit et on stocke dans une mémoire RAM le raccourci entre le secteur d'origine et le dernier secteur de remplacement.

6. Procédé selon la revendication 3, **caractérisé en ce que** la manière de mettre à jour la zone de management est conçue pour être robuste par rapport à des pertes éventuelles d'alimentation, de manière à éviter toute corruption de ladite zone de management.

7. Dispositif pour la mise en oeuvre du procédé de gestion d'endurance selon l'une quelconque des revendications précédentes, **caractérisé en ce qu'**il comporte une mémoire partitionnée en une pluralité de secteurs de travail et de secteurs de remplacement, une zone de management des secteurs de remplacement, un automate apte à exécuter les étapes du procédé selon l'une quelconque des revendications 1 à 6.

## Patentansprüche

1. Verfahren zur Verwaltung der Belastbarkeit eines Datenspeichersystems, versehen mit einer Einheit von Sektoren (33, 34), die an eine garantierte ursprüngliche Belastbarkeitskapazität (G) angepasst sind, umfassend die Schritte bestehend aus:
- Teilen des Datenspeichersystems in eine Vielzahl von Arbeitssektoren (33) und eine Vielzahl von Ersatzsektoren (34), die ausgelegt sind, um ein Belastbarkeitsreservoir zu bilden, wobei bestimmte Arbeitssektoren (33) dazu vorgesehen sind, durch bestimmte Ersatzsektoren (34) ersetzt zu werden, wenn die Arbeitssektoren (33) nach einer bestimmten Anzahl von Programmier- und/oder Löschzyklen abgenutzt sind;
- Definieren eines Adressmanagementbereichs (35), der ermöglicht, die Stelle der Ersatzsektoren wiederzufinden, die von den abgenutzten Arbeitssektoren betroffen sind;
- Bestimmen, von Sektor zur Sektor, ob ein laufender Arbeitssektor (33) physisch abgenutzt ist, und Durchführen eines Schritts des Ersetzens dieses Arbeitssektors (33) durch einen Ersatzsektor (34) nur, wenn der laufende Arbeitssektor (33) als physisch abgenutzt erklärt wird,
- Messen der Abnutzung eines Sektors durch Durchführen einer automatischen Lektüre der Löschqualität der Speicherpunkte des Sektors mit Bezug auf ein Lektürekriterium im verstärkten Modus, d. h. stärker als ein Lektürekriterium im normalen Modus, mit einem Vergleich einer Schwellenspannung Vt des laufenden Speicherpunkts mit einer festen Referenz, bezeichnet als Normal Vref, die sich zwischen zwei Grenzspannungen Vtmin und Vtmax im normalen Modus befindet, mit einem Vergleich der Schwellenspannung des laufenden Speicherpunkts mit einer weiteren Referenz, bezeichnet als Margin Vref, die größer als Vtmax aber kleiner als die Referenz Normal Vref im verstärkten Modus ist,
**dadurch gekennzeichnet, dass** ein einziger Löschimpuls eines Sektors durch mehrere kürzere Impulse ersetzt wird, die auf sequenzielle Weise angewendet werden, und dadurch, dass ein Löschqualitätstest (54) nach jedem Impuls ausgeführt wird, wobei ein Arbeitsspeichersektor als abgenutzt erklärt wird, wenn die Qualitätstests nach einer vorbestimmten maximalen Anzahl von Impulsen und Tests negativ bleiben.

2. Verfahren nach einem der vorhergehenden Ansprüche, **dadurch gekennzeichnet, dass**:
- ein vollständig generischer Speicher mit einer regelmäßigen Struktur verwendet wird, bei der es keinen physischen Unterschied zwischen einem ursprünglichen Sektor und einem Ersatzsektor gibt;
- die Anzahl von Ersatzsektoren (34) vom Endbenutzer je nach den angestrebten Belastbarkeitserfordernissen festgelegt werden kann;
- ein Arbeitssektor (33), ersetzt durch einen Ersatzsektor (34), selbst ein Arbeitssektor (33) wird, der ersetzt werden kann, wenn er eine Schwelle physischer Abnutzung erreicht hat.

3. Verfahren nach Anspruch 2, **dadurch gekennzeichnet, dass**, um das Fortschreiten zwischen ersetzten Sektoren und Ersatzsektoren (34) zu rekonstruieren, ein Managementbereich des nicht flüchtigen Speichers verwendet wird, wobei jedes Element des Bereichs spezifisch für einen Ersatzsektor ist und die Adresse des ersetzten ursprünglichen Sektors darstellt.

4. Verfahren nach Anspruch 3, **dadurch gekennzeichnet, dass** der Rekonstruktionsweg zwischen dem ursprünglichen Sektor und dem Ersatzsektor (34), der den Managementbereich verwendet, beim Zugriff auf den ursprünglichen Sektor in Echtzeit bestimmt wird.

5. Verfahren nach Anspruch 3, **dadurch gekennzeichnet, dass** das Fortschreiten zwischen dem ursprünglichen Sektor und dem Ersatzsektor (34) beim Start der Schaltung rekonstruiert wird und in einem RAM-Speicher die Abkürzung zwischen dem ursprünglichen Sektor und dem letzten Ersatzsektor gespeichert wird.

6. Verfahren nach Anspruch 3, **dadurch gekennzeichnet, dass** die Art der Aktualisierung des Managementbereichs entworfen ist, um mit Bezug auf eventuelle Versorgungsverluste robust zu sein, um jede Korruption des Managementbereichs zu vermeiden.

7. Vorrichtung für die Durchführung des Verfahrens zur Verwaltung der Belastbarkeit nach einem der vorhergehenden Ansprüche, **dadurch gekennzeichnet, dass** sie einen Speicher umfasst, der in eine Vielzahl von Arbeitssektoren und Ersatzsektoren geteilt ist, einen Managementbereich der Ersatzsektoren, einen Automaten, der ausgelegt ist, um die Schritte des Verfahrens nach einem der Ansprüche 1 bis 6 durchzuführen.

## Claims

1. Method of managing the endurance of a data storage system provided with a set of sectors (33, 34) associated with a guaranteed native endurance capacity (G), comprising steps for:
- partitioning said data storage system into a plurality of working sectors (33) and into a plurality of spare sectors (34) capable of forming an endurance reservoir, some of the working sectors (33) being intended to be replaced by spare sectors (34) when said working sectors (33) are bad after a certain number of programming and/or erase cycles;
- defining an address management zone (35) to find the location of replacement sectors assigned to bad working sectors;
- determining, sector by sector, if a current working sector (33) is physically bad, and performing a step to replace this working sector (33) by a spare sector (34), only when said current working sector (33) is declared as being physically bad;
- measuring the wear of a sector, by performing an automatic read of the erase quality of the memory points of the sector compared with a read criterion in margin mode, in other words more severe than a read criterion in normal mode, with a comparison of a threshold voltage Vt of the current memory point with a fixed reference, denoted Normal Vref, situated between two limiting voltages Vtmin and Vtmax in normal mode and with a comparison of the threshold voltage of the current memory point with another reference, denoted Margin Vref, greater than Vtmax but less than the reference Normal Vref in margin mode,
**characterised in that** a single pulse to erase a sector is replaced by several shorter sequentially applied pulses, and **in that** an erase quality test (54) is performed after each pulse, a working memory sector being declared as being bad if said quality tests remain negative after a maximum predefined number of pulses and tests.

2. Method according to any one of the previous claims, **characterised in that**:
- a perfectly generic memory with a regular structure will be used in which there is no physical difference between an original sector and a spare sector;
- the number of spare sectors (34) may be determined by the end user as a function of target endurance needs;
- a working sector (33) replaced by a spare sector (34) itself becomes a working sector (33) that can be replaced when it has reached its physical wear threshold.

3. Method according to claim 2, **characterised in that** for reconstructing the path between replaced sectors and spare sectors (34), a non-volatile memory management zone is used in which each element in the zone is specific to a spare sector and is the address of the replaced original sector.

4. Method according to claim 3, **characterised in that** the reconstruction path between the original sector and the spare sector (34) using the management zone is determined in real time during the access to the original sector.

5. Method according to claim 3, **characterised in that** the path between the original sector and the spare sector (34) is reconstructed when the circuit is powered up, and the shortcut between the original sector and the final spare sector is stored in a RAM memory.

6. Method according to claim 3, **characterised in that** the method of updating the management zone is designed to resist power supply losses, in order to prevent corruption of said management zone.

7. Device for implementing the endurance management method according to any one of the previous claims, **characterised in that** it comprises a memory partitioned into a plurality of working sectors and spare sectors, a zone for managing spare sectors, and a logic controller capable of performing the steps in the method according to any one of claims 1 to 6.
